# EUROPEAN PATENT APPLICATION

(11) **EP 4 685 506 A1**
(43) Date of publication of application: **28.01.2026**
(21) Application number: 24880032.8
(22) Date of filing: 08.10.2024
(51) Int. Cl.: G01R 31/385, G01R 31/392, H01M 10/42

(54) **CYCLING TEST DEVICE**

(30) Priority: 18.10.2023 KR 20230139822
(71) Applicant: LG Energy Solution, Ltd., Seoul 07335 (KR)
(72) Inventor: JANG, Eun Su, Daejeon 34122 (KR); LIM, Jae Kwon, Daejeon 34122 (KR); KIM, Kyeong Rok, Daejeon 34122 (KR)
(74) Representative: Goddar, Heinz J.
(86) International application number: PCT/KR2024/015262
(87) International publication number: WO 2025/084694

(57) **Abstract**

A cycling test device related to one example of the present invention comprises a chamber having a space portion for accommodating a battery and having a plurality of partitions forming the space portion, a first temperature adjustment part supplying the space portion with air and including a first refrigerator provided to control a temperature of the supplied air, and a second temperature adjustment part provided to cool one or more partitions.

## Description

### Technical Field

The present invention relates to a cycling test device, and particularly, relates to a cycling test device for a secondary battery.

This application claims the benefit of priority based on Korean Patent Application No. 10-2023-0139822 dated October 18, 2023, the disclosure of which is incorporated herein by reference in its entirety.

### Background Art

To test a service life of a product under constant temperature conditions such as a high temperature environment or a low temperature environment, a constant temperature chamber is used.

A cycler device is used for a cycling test of a secondary battery, and the cycler device is a secondary battery post-process device, which is used for performance and lifespan tests of a battery, and the like.

The cycler has a space portion where a battery to be tested is accommodated, and comprises an air conditioner for controlling and maintaining a temperature within the space portion. In addition, the battery accommodated in the space portion is electrically connected to a charge and discharge device for a charge and discharge performance test.

Usually, the air conditioner of the cycler is equipped to perform a constant temperature operation maintaining the temperature in the space portion at a set temperature during the test period.

The air conditioner comprises a refrigerator including a heat exchanger for cooling, a heater, and a circulation fan, which is provided so that the air circulated by the circulation fan is primarily heat-removed through the heat exchanger for cooling, and the cooled air is heated with heat supplied from the heater, and then supplied to the space portion.

That is, in the constant temperature chamber for the cycling test of the secondary battery, a convection method controlling the temperature inside the chamber by cooling and heating the air circulating the inside of the space portion is applied.

However, a heat transfer coefficient value (h) by natural convection of air is 5 to 50 W/m²K, and a heat transfer coefficient value (h) by forced convection is 25 to 250 W/m²K or so, where the conventional cycling test chamber is a system controlling the temperature inside the chamber through heat transfer by forced convection of circulating air, which has a problem of an insufficient energy conversion efficiency.

Also, in the case of test facilities that require high temperature control performance (cooling/heating rate), refrigerators and heaters with higher specifications are applied.

Particularly, in the case of the convection heat transfer, as the chamber internal space increases, the probability that the heat source supplied for temperature control and the target whose temperature is to be controlled meet decreases, thereby resulting in a lower heat transfer efficiency. That is, the air fluidly moving away from a body to be heated/cooled does not participate in the heat transfer, which causes a lower energy efficiency.

In addition, in the case of the refrigerator, there is a limit to active control compared to the heater, whereby it is provided to maintain a cooling performance of a certain amount or more, or close to the design value, and accordingly, the refrigerator and heater are operated, regardless of the heat load generated inside the chamber, to maintain the chamber temperature, so that there is a problem that the thermal efficiency is reduced due to the characteristics of the device performing long-term tests.

### Disclosure

### Technical Problem

It is a technical problem to be solved by the present invention to provide a cycling test device capable of maintaining and controlling a temperature of a test chamber through a convection heat transfer method and a conduction heat transfer method.

Also, it is a technical problem to be solved by the present invention to provide a cycling test device capable of improving a thermal efficiency and increasing control responsiveness by primarily controlling a temperature of a space portion through a convection method and directly cooling a chamber wall surface of the space portion through a conduction method in response to a change of heat load in the space portion.

In addition, it is a technical problem to be solved by the present invention to provide a cycling test device capable of individually controlling temperatures of a plurality of space portions.

Furthermore, it is a technical problem to be solved by the present invention to provide a cycling test device capable of increasing a utilization degree of a space within the test device, easily discharging heat generated inside to the outside, and increasing a utilization degree of an installation space.

### Technical Solution

In order to solve the above problem, according to one aspect of the present invention, a cycling test device is provided, which comprises a chamber having a space portion for accommodating a battery and having a plurality of partitions forming the space portion, a first temperature adjustment part supplying the space portion with air and including a first refrigerator provided to control a temperature of the supplied air, and a second temperature adjustment part provided to cool one or more partitions.

Also, the second temperature adjustment part may be provided to directly cool the partition by contacting the partition.

In addition, the second temperature adjustment part may comprise a cooling flow channel part disposed in the partition, and a heat medium fluidly moving through the cooling flow channel part.

Furthermore, the heat medium may comprise refrigerant, cooling water, antifreeze, thermal oil, or air. In addition, the heat medium may be cold water or cooling water supplied from a utility within a factory facility where the cycling test device is installed.

Also, the second temperature adjustment part may comprise a second refrigerator for controlling the temperature of the heat medium. For example, the second refrigerator may comprise a compressor for compressing the heat medium, a condenser, an evaporator, and an expansion valve.

In addition, the cooling flow channel part may be disposed to surround a predetermined region or more of the partition.

Furthermore, the partition may comprise an inner wall surrounding the space portion, and an outer wall surrounding the inner wall, and the cooling flow channel part may be formed between the inner wall and the outer wall.

Also, the second temperature adjustment part may comprise a second heater for heating the partition. In this way, the second temperature adjustment part may directly cool or heat one or more partitions.

In addition, the second temperature adjustment part may comprise a thermoelectric element.

Furthermore, the first refrigerator may comprise a compressor for compressing refrigerant, a condenser, an expansion valve, and an evaporator.

Also, the first temperature adjustment part may comprise a first heater for heating air passing through the evaporator, and a fan for fluidly moving the air temperature-controlled through the first temperature adjustment part into the space portion.

In addition, the cycling test device may comprise a housing including a first case surrounding the plurality of partitions of the chamber and a second case partitioned from the first case.

As one example, the evaporator and the fan may be disposed in a space between the first case and the partitions, and the compressor and the condenser may each be disposed in the second case.

Also, the plurality of partitions may comprise a pair of facing side walls and a rear wall connecting the pair of side walls. As one example, a plurality of fluid holes may be formed in any one of the side walls, or the rear wall, and the air passing through the evaporator and the fan may flow into the space portion through the fluid holes.

In addition, the second temperature adjustment part may be provided on one of upper and lower walls connecting the pair of side walls among the plurality of partitions.

Furthermore, the cycling test device may comprise one or more temperature sensors for measuring a temperature within the space portion, and a control part provided so that the first temperature adjustment part is driven upon a constant temperature operation of the space portion, and the second temperature adjustment part is driven upon a cooling operation of the space portion, based on temperature information within the space portion.

The control part may be provided to operate the first refrigerator, the first heater, and the fan upon the constant temperature operation.

Also, the control part may be provided to operate the first refrigerator and the second temperature adjustment part, respectively, upon the cooling operation.

In addition, the control part may be provided to operate the second temperature adjustment part and the fan, respectively, upon the cooling operation.

Furthermore, according to another aspect of the present invention, a cycling test device is provided, which comprises a chamber having a plurality of space portions for accommodating batteries and having a plurality of partitions forming each space portion, a first temperature adjustment part supplying each space portion with air and including a first refrigerator provided to control a temperature of the supplied air, and a plurality of second temperature adjustment parts provided to cool one or more partitions of each space portion.

The cycling test device may comprise a plurality of temperature sensors for measuring a temperature within each space portion, and a control part provided to individually control the plurality of second temperature adjustment parts based on temperature information within each space portion.

Also, the control part may be provided so that for each space portion, the first temperature adjustment part is driven upon a constant temperature operation, and the second temperature adjustment part is driven upon a cooling operation.

In addition, the control part may be provided to operate the first and second temperature adjustment parts simultaneously upon the cooling operation.

### Advantageous Effects

'As described above, the cycling test device related to one example of the present invention has the following effects.

By applying one heat transfer method among the convection heat transfer method and the conduction heat transfer method or two heat transfer methods together, the temperature of the test chamber during which the cycling test is performed can be maintained and controlled.

Also, by primarily controlling the temperature of the space portion through the convection method, and directly cooling the chamber wall surface of the space portion through the conduction method in response to the change of the heat load in the space portion, the thermal efficiency can be improved and the control responsiveness can be increased.

In addition, by individually providing temperature adjustment parts of the conduction method for the plurality of space portions, the temperatures can be individually controlled in response to the change of the heat load for each space portion.

Furthermore, by appropriately disposing the main elements of the temperature adjustment part considering the thermal characteristics, the utilization degree of the space within the test device can be increased, the heat generated inside can be easily discharged to the outside, and the utilization degree of the installation space can be increased.

### Description of Drawings

Figure 1 is a perspective diagram schematically showing a cycling test device related to one example of the present invention.
Figure 2 is a schematic configuration diagram of the cycling test device illustrated in Figure 1.
Figure 3 is a schematic perspective diagram of a chamber constituting a cycling test device.
Figure 4 is a schematic configuration diagram of the cycling test device illustrated in Figure 3.
Figures 5 to 7 are schematic diagrams showing one example of a second temperature adjustment part constituting a cycling test device.
Figure 8 is a configuration diagram schematically showing a cycling test device related to another example of the present invention.

### Mode for Invention

Hereinafter, a cycling test device according to one example of the present invention will be described in detail with reference to the attached drawings.

In addition, regardless of the reference numerals, the same or corresponding components are given by the same or similar reference numerals, duplicate descriptions thereof will be omitted, and for convenience of explanation, the size and shape of each component member as shown can be exaggerated or reduced.

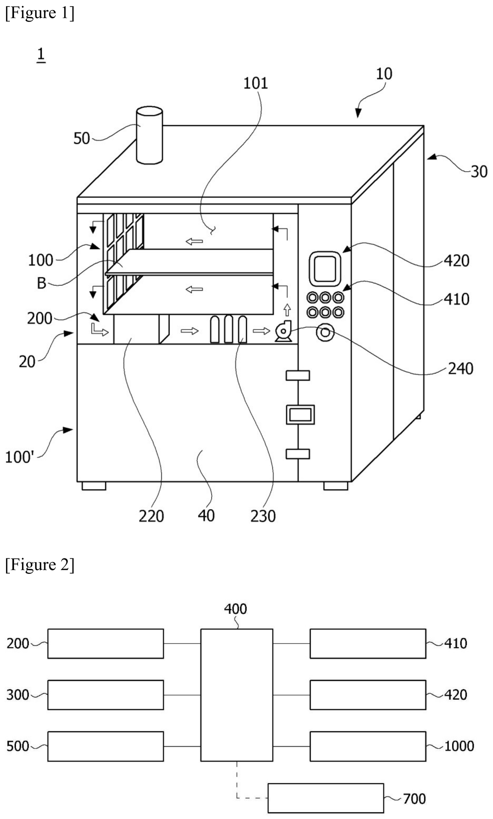

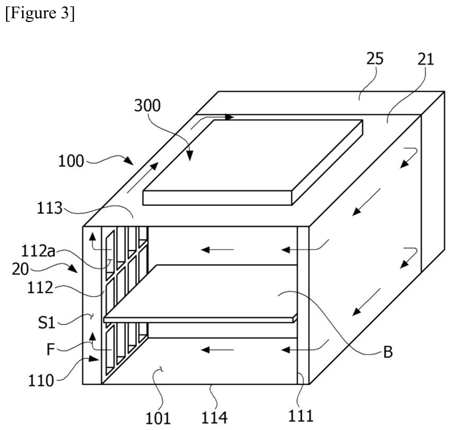

Figure 1 is a perspective diagram schematically showing a cycling test device (1) related to one example of the present invention, Figure 2 is a schematic configuration diagram of the cycling test device illustrated in Figure 1, and Figure 3 is a schematic perspective diagram of a chamber constituting a cycling test device.

The cycling test device (1) comprises a chamber (100) having a space portion (101) for accommodating a battery (B) and having a plurality of partitions (110) forming the space portion (101). The space portion (101) may be a test space where a cycling test of the battery (B) is performed.

In addition, the cycling test device (1) may comprise an operation part (410) for inputting the device's on/off and a test temperature within the chamber (100), and a display part (420) for displaying operation information including the test temperature, and the like.

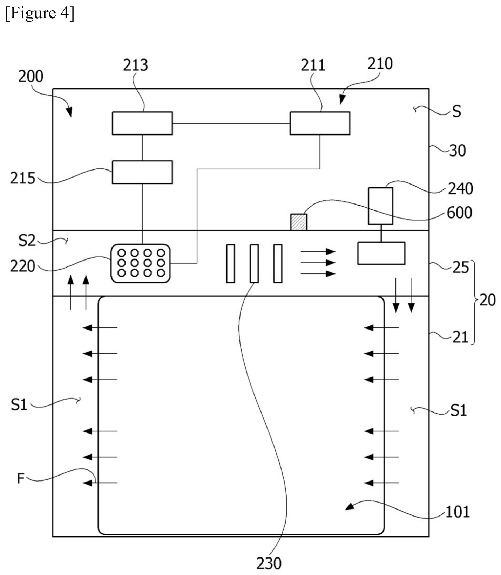

Figure 4 is a schematic configuration diagram of the cycling test device illustrated in Figure 3.

The battery (B) may be a secondary battery, and may be a secondary battery with various types such as a pouch type, a cylindrical type, or a rectangular type. In addition, a plurality of batteries (B) may be accommodated in the space portion (101), and for the batteries (B) accommodated in the same space portion (101), the cycling test may be performed under the same temperature conditions.

Also, the battery (B) may be accommodated in the space portion (101) in a state of being mounted on a charging jig (700), and the charging may be performed through the charging jig (700). To this end, a connector (600) for electrically connecting to the charging jig (700) may be provided in the chamber (100).

In addition, the cycling test device (1) may comprise a charge and discharge part (1000) for charging the battery (B) through the charging jig. At this time, the charge and discharge part (1000) may also be disposed inside the cycling test device (1), and may be disposed outside the cycling test device (1) and may be electrically connected to the connector (600) inside the test device (1) through a cable or the like.

Furthermore, the test device (1) may comprise a plurality of chambers (100). In Figure 1, two chambers (100, 100') arranged vertically are illustrated, but the number of chambers (100) may be determined in various ways.

The cycling test device (1) comprises a first temperature adjustment part (200) supplying the space portion (101) with air and including a first refrigerator (210) provided to control a temperature of the supplied air.

The first temperature adjustment part (200) may be provided to control the temperature of the space portion (101) by a convection method of air.

As one example, the first refrigerator (210) comprises a compressor (211) for compressing refrigerant, a condenser (213) through which the refrigerant compressed in the compressor (211) passes, an expansion valve (215) through which the refrigerant passing through the condenser (213) is supplied, and an evaporator (220) through which the refrigerant passing through the expansion valve (215) is supplied. The air (F) circulating in the space portion (101) of the chamber (100) is cooled in a process of passing through the evaporator (220).

Also, the first temperature adjustment part (200) may comprise a first heater (230) for heating the air passing through the evaporator (220). The first heater (230) may be provided with one or more heaters along a flow direction of the air. The air cooled in the process of passing through the evaporator (220) is heated in a process of passing through the first heater (230), and then supplied to the space portion (101).

In addition, the first temperature adjustment part (200) may comprise a fan (240) for fluidly moving the air, in which the temperature is controlled through the first refrigerator (210) and the first heater (230), into the space portion (101). While the air sequentially passing through the evaporator (220) and the first heater (230) is supplied to the space portion (101) in the chamber (100) by the fan (240), and the air discharged from the space portion (101) sequentially passes through the evaporator (220) and the first heater (230), the temperature may be controlled.

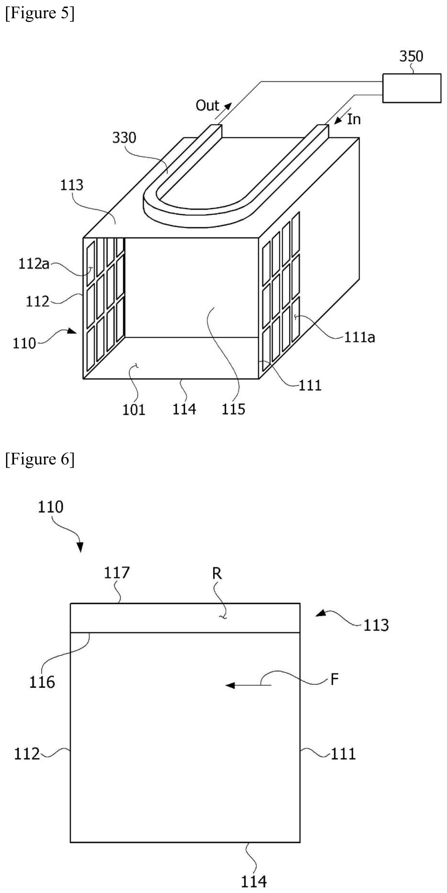

Figures 5 to 7 are schematic diagrams showing one example of a second temperature adjustment part constituting a cycling test device.

Referring to Figure 3, the cycling test device (1) comprises a second temperature adjustment part (300) provided to cool one or more partitions (e.g., upper wall 113) among the plurality of partitions (110: 111 to 114) forming the space portion (101).

The second temperature adjustment part (300) may be provided to directly cool the partition (e.g., upper wall 113) by contacting the partition (e.g., upper wall 113). The second temperature adjustment part (300) may be provided to control the temperature of the space portion (101) in a conduction manner that directly cools the partition.

In addition, the second temperature adjustment part (300) may comprise a second heater (not shown) for heating any one of the partitions. In this way, the second temperature adjustment part (300) may be provided so that one or more partitions are directly cooled, or heated.

Particularly, when the test temperature condition of the space portion (101) changes, the second temperature adjustment part (300) is provided so that to quickly increase a heat flux of the partition in the chamber (100), the partition of the chamber (100) is directly cooled, or heated in a conduction manner.

Referring to Figures 1 and 4, the cycling test device (1) may comprise a housing (10) forming the appearance of the device. One or more chambers (100) are disposed inside the housing (10). Also, the chambers (100) may be provided with a plurality of chambers inside the housing (10), and may have a structure opened toward one side of the housing (10). In addition, doors (40) may be provided on the housing (10) to seal the open side of the chamber (100). Figure 1 illustrates a state where two chambers (100, 100') are arranged vertically, and the chamber (100') located at the lower portion is illustrated in a closed state by the door (40), and the chamber (100) located at the upper portion is illustrated in a state where the door is omitted.

The chamber (100) may have an approximately rectangular parallelepiped shape, and may have a form in which one side is opened.

The plurality of partitions (110) may comprise a pair of facing side walls (111, 112), and the plurality of partitions (110) may also comprise a rear wall (115, see Figure 5) connecting the pair of side walls (111, 112). The rear wall (115) corresponds to a surface facing the open surface (or door) of the chamber (100). At this time, a plurality of fluid holes may be formed in any one of the side walls (111, 112), or the rear wall (115), and the air passing through the evaporator (220) and the fan (240) may flow into the space portion (101) through the fluid holes.

As one example, a plurality of fluid holes (111a, 112a) may be formed in each of the side walls (111, 112). At this time, while the air (F) passing through the evaporator (220) and the fan (240) flows into the space portion (101) through the fluid holes (111a) of any one side wall (111), and the air in the space portion (101) is discharged to the outside of the space portion (101) through the other side wall (112), and then sequentially passes through the evaporator (220) and the first heater (230), the temperature may be controlled. In this structure, a horizontal airflow may be formed within the chamber (100).

Also, in a state where the door (40) is closed, the space portion (101) may be sealed by the plurality of partitions (110) and the door (40), and air may fluidly move into the inside and the outside of the space portion (101) through a plurality of fluid holes (111a, 112a) formed in each of the side walls (111, 112).

On the contrary, the plurality of partitions (110) may comprise an upper wall (113) and a lower wall (114) connecting the pair of side walls, and a plurality of fluid holes may be formed in the upper wall (113) and the lower wall (114), and the air passing through the evaporator (220) and the fan (240) may flow into the space portion (101) through the fluid holes of the upper wall (113) and the lower wall (114). In this structure, a vertical airflow may be formed within the chamber (100).

Also, the second temperature adjustment part (300) may be provided in any one of the partitions (110). As one example, the second temperature adjustment part (300) may also be provided in one of the upper wall (113) and the lower wall (114) connecting the pair of side walls among the plurality of partitions. In addition, the second temperature adjustment part (300) may be provided to surround a predetermined region or more of the partition (upper wall or lower wall).

In addition, the housing (10) may comprise a first case (20) surrounding the plurality of partitions (110) of the chamber (100) and a second case (30) partitioned from the first case (20). The chamber (100) is disposed inside the first case (20). The partition (110) forming the space portion (101) of the chamber (100) may be disposed at a predetermined distance from the inner surface of the first case (20), and accordingly, a space (S1) where air is fluidly movable may be formed between the partition (110) and the first case (20). The cases may be arranged in such a way that the second case (30) is mounted on the first case (20), and the first case (20) is positioned at the front of the device (1), and the second case (30) is positioned at the rear of the device (1).

As one example, the evaporator (220) and the fan (240) may be disposed in the space (S1) between the first case (20) and the partition (110). The first case (20) may comprise a first member (21) surrounding the pair of side walls of the test chamber (100), and a second member (25) partitioned from the first member (21) and surrounding the partition (rear wall) forming the rear surface of the space portion (101).

The first member (21) and the second member (25) may each be partitioned to have separate spaces, and the first member (21) and the second member (25) may be connected so that air is fluidly movable.

The evaporator (220), the first heater (230), and the fan (240) may be arranged in the internal space (S2) of the second member (25), where in the inside of the second member (25), the evaporator (220) may be disposed on the upstream side along the air flow direction, and the first heater (230) may be disposed on the downstream side sequentially.

That is, the space (S1) between the first member (21) and the side walls (111, 112) of the chamber and the internal space (S2) of the second member (25) may be connected to be fluidly movable.

Referring to Figures 3 and 4, after the air (F) discharged from the space portion (101) flows into the internal space (S2) of the second member (25) through the space (S1) between the first member (21) and the side wall (112) of the chamber, and passes through the evaporator (220) and the first heater (230) disposed inside the second member (25) sequentially, and then fluidly moves into the space (S1) between the first member (21) and the side wall (112) of the chamber, it may be supplied to the space portion (101).

Referring to Figure 4, the compressor (211) and the condenser (213) may each be disposed in the second case (30), and the expansion valve (215) may also be disposed in the second case (30).

In addition, an exhaust port (50, see Figure 1) connected to the second case (30) may be exposed to the outside of the housing (10), and may be provided to be air-releasable to the upper portion of the device (1). High-temperature air of the inside (S) of the second case (30) may be discharged to the outside of the device (1) through the exhaust port (50).

Referring to Figure 5, the second temperature adjustment part (300) may comprise a cooling flow channel part (330) disposed in the partition (upper wall or lower wall) and a heat medium fluidly moving the cooling flow channel part (330). As one example, the heat medium may comprise refrigerant, cooling water, antifreeze, thermal oil, or air.

In addition, the cooling flow channel part (330) may be disposed to surround a predetermined region or more of the partition (upper wall or lower wall), and may be disposed to surround a predetermined region or more of the partition (upper wall or lower wall), for example, in a zig-zag shape.

The cooling flow channel part (330) may be configured in the form of a pipe through which the heat medium fluidly moves. When the cooling flow channel part (330) is configured in the form of a pipe, the cooling pipe may be arranged to contact the partition (upper wall or lower wall).

Also, the cooling flow channel part (330) may be connected to a second refrigerator (350) for controlling the temperature of the heat medium. For example, the second refrigerator may comprise a compressor for compressing the heat medium, a condenser, an expansion valve, and an evaporator.

In addition, the heat medium may be cold water or cooling water supplied from a utility within a factory facility where the cycling test device (1) is installed.

Referring to Figure 6, the partition (e.g., upper wall 113) may comprise an inner wall (116) surrounding the space portion (101) and an outer wall (117) surrounding the inner wall (116). That is, either the upper wall (113) or the lower wall (114) may have a double wall structure. For example, when the upper wall (113) has a double wall structure, the cooling flow channel part (330) may be formed between (R) the inner wall (116) and the outer wall (117). In this way, the interspace (R) of the double wall structure may be used as the cooling flow channel part (330) without installing a separate pipe.

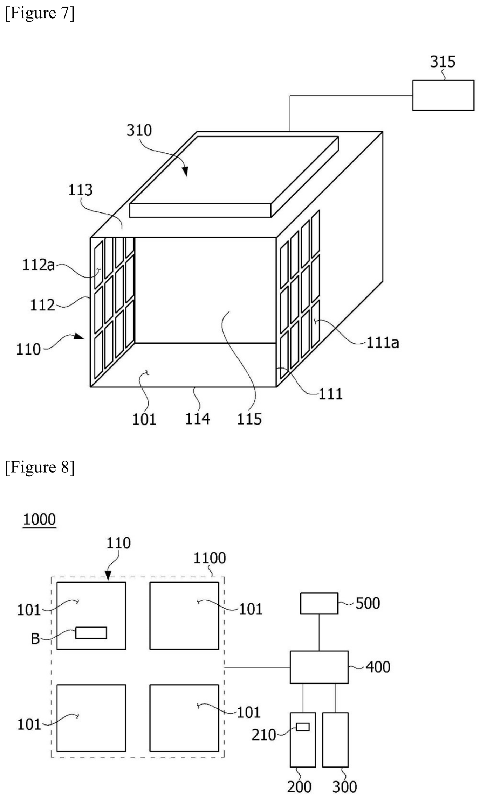

Referring to Figure 7, the second temperature adjustment part (300) may comprise a thermoelectric element (Peltier element, 310). The thermoelectric element (310) may be provided in one or more elements. Also, the thermoelectric element (310) may be disposed to surround a predetermined region or more of the partition (upper wall or lower wall). In addition, the thermoelectric element (310) may be connected to a drive circuit part (315) for driving the thermoelectric element (310). The thermoelectric element (310) may comprise a heat absorption part and a heat generation part, and may be provided to directly cool the partition as the heat absorption part contacts the partition.

Referring to Figure 2, the cycling test device (1) may comprise one or more temperature sensors (500) for measuring the temperature within the space portion (101).

The cycling test device (1) may comprise a plurality of temperature sensors (500), where the plurality of temperature sensors (500) may be disposed to measure the temperatures for each region of the space portion (101), respectively.

In addition, the cycling test device (1) may comprise a control part (400) provided so that the first temperature adjustment part (200) is driven upon a constant temperature operation of the space portion (101), and the second temperature adjustment part (300) is driven upon a temperature change of the space portion (101), based on temperature information within the space portion (101).

For example, the control part (400) may be provided so that the first temperature adjustment part (200) is driven upon a constant temperature operation of the space portion (101), and the second temperature adjustment part (300) is driven upon a cooling operation, based on temperature information within the space portion (101).

In addition, the control part (400) may be provided to operate the first refrigerator (210), the first heater (230), and the fan (240) upon the constant temperature operation. That is, the control part (400) may drive the first temperature adjustment part (200) upon the constant temperature operation and may not drive the second temperature adjustment part (300). In this document, the constant temperature operation means an operation to maintain the temperature of the space portion (101) at a set temperature, which may also include an operation within a set temperature range.

Meanwhile, depending on the variation of the heat load or test temperature within the space portion (101), the cooling operation for lowering the temperature to a set temperature may be performed.

The control part (400) is provided to drive the first refrigerator (210) and the second temperature adjustment part (300) upon the cooling operation. That is, upon the cooling operation, the control part (400) may drive the first temperature adjustment part (200) in the same manner as upon the constant temperature operation, and may simultaneously operate the second temperature adjustment part (300).

Meanwhile, upon the cooling operation, the control part (400) may operate the second temperature adjustment part (300) and the fan (240), respectively. Specifically, the control part (400) may be provided to perform the cooling operation by excluding the temperature adjustment function through the first refrigerator (210) and operating only the second temperature adjustment part (300) and the fan (240).

Figure 8 is a configuration diagram schematically showing a cycling test device (1000) related to another example of the present invention.

Referring to Figure 8, the cycling test device (1000) related to another example of the present invention comprises a chamber (1100) having a plurality of space portions (101) for accommodating batteries (B) and having a plurality of partitions (110) forming each space portion (101).

In addition, the cycling test device (1000) comprises a first temperature adjustment part (200) supplying each space portion (101) with air and including a first refrigerator (210) provided to control a temperature of the supplied air, and a plurality of second temperature adjustment parts (300) provided to cool one or more partitions (110) of each space portion (101).

In the present example, the first temperature adjustment part (200) may be used in common for the plurality of space portions (101), and the second temperature adjustment parts (300) may be individually applied to the respective space portions (101).

In addition, the cycling test device (1000) may comprise a plurality of temperature sensors (500) for measuring a temperature within each space portion (101), and a control part (400) provided to individually control the plurality of second temperature adjustment parts (300) based on temperature information within each space portion (101).

The control part (400) may be provided so that for each space portion (101), the first temperature adjustment part (200) is driven upon a constant temperature operation, and the second temperature adjustment part (300) is driven upon a temperature change. For example, the control part (400) may be provided so that for each space portion (101), the first temperature adjustment part (200) is driven upon a constant temperature operation, and the second temperature adjustment part (300) is driven upon a cooling operation.

In addition, the control part (400) may be provided to operate the first and second temperature adjustment parts (200, 300) simultaneously upon the cooling operation.

According to the present example, when the heat load fluctuation is different for each space portion, the cooling operation may be performed for each space portion (101) by individually controlling the second temperature adjustment parts (300) provided in the respective space portions (101).

The preferred examples of the present invention as described above have been disclosed for illustrative purposes, and those skilled in the art having ordinary knowledge of the present invention will be able to make various modifications, changes, and additions within the spirit and scope of the present invention, and such modifications, changes, and additions should be regarded as falling within the scope of the following claims.

### Industrial Applicability

According to the cycling test device related to one example of the present invention, by primarily controlling the temperature of the space portion through the convection method, and directly cooling the chamber wall surface of the space portion through the conduction method in response to the change of the heat load in the space portion, the thermal efficiency can be improved and the control responsiveness can be increased.

## Claims

1. A cycling test device comprising:
a chamber having a space portion for accommodating a battery and having a plurality of partitions forming the space portion;
a first temperature adjustment part supplying the space portion with air and including a first refrigerator provided to control a temperature of the supplied air; and
a second temperature adjustment part provided to cool one or more partitions.

2. The cycling test device according to claim 1, wherein
the second temperature adjustment part is provided to directly cool the partition by contacting the partition.

3. The cycling test device according to claim 2, wherein
the second temperature adjustment part comprises a cooling flow channel part disposed in the partition, and a heat medium fluidly moving through the cooling flow channel part.

4. The cycling test device according to claim 3, wherein
the second temperature adjustment part comprises a second refrigerator for controlling the temperature of the heat medium.

5. The cycling test device according to claim 3, wherein
the cooling flow channel part is disposed to surround a predetermined region or more of the partition.

6. The cycling test device according to claim 3, wherein
the partition comprises an inner wall surrounding the space portion, and an outer wall surrounding the inner wall, and
the cooling flow channel part is formed between the inner wall and the outer wall.

7. The cycling test device according to claim 3, wherein
the second temperature adjustment part comprises a second heater.

8. The cycling test device according to claim 2, wherein
the second temperature adjustment part comprises a thermoelectric element.

9. The cycling test device according to claim 1, wherein
the first refrigerator comprises a compressor for compressing refrigerant, a condenser, an expansion valve, and an evaporator, and
the first temperature adjustment part comprises a first heater for heating air passing through the evaporator, and a fan for fluidly moving the air temperature-controlled through the first temperature adjustment part into the space portion.

10. The cycling test device according to claim 9, comprising
a housing including a first case surrounding the plurality of partitions of the chamber and a second case partitioned from the first case, wherein
the evaporator and the fan are disposed in a space between the first case and the partitions.

11. The cycling test device according to claim 10, wherein
the compressor and the condenser are each disposed in the second case.

12. The cycling test device according to claim 10, wherein
the plurality of partitions comprises a pair of facing side walls and a rear wall connecting the pair of side walls,
a plurality of fluid holes is formed in any one of the side walls, or the rear wall, and
the air passing through the evaporator and the fan flows into the space portion through the fluid holes.

13. The cycling test device according to claim 12, wherein
the second temperature adjustment part is provided on one of upper and lower walls connecting the pair of side walls among the plurality of partitions.

14. The cycling test device according to claim 9, further comprising:
one or more temperature sensors for measuring a temperature within the space portion; and
a control part provided so that the first temperature adjustment part is driven upon a constant temperature operation of the space portion, and the second temperature adjustment part is driven upon a cooling operation of the space portion, based on temperature information within the space portion.

15. The cycling test device according to claim 14, wherein
the control part operates the first refrigerator, the first heater, and the fan upon the constant temperature operation.

16. The cycling test device according to claim 14, wherein
the control part operates the first refrigerator and the second temperature adjustment part, respectively, upon the cooling operation.

17. The cycling test device according to claim 14, wherein
the control part operates the second temperature adjustment part and the fan, respectively, upon the cooling operation.

18. A cycling test device comprising:
a chamber having a plurality of space portions for accommodating batteries and having a plurality of partitions forming each space portion;
a first temperature adjustment part supplying each space portion with air and including a first refrigerator provided to control a temperature of the supplied air; and
a plurality of second temperature adjustment parts provided to cool one or more partitions of each space portion.

19. The cycling test device according to claim 18, comprising:
a plurality of temperature sensors for measuring a temperature within each space portion; and
a control part provided to individually control the plurality of second temperature adjustment parts based on temperature information within each space portion.

20. The cycling test device according to claim 19, wherein
the control part is provided so that for each space portion, the first temperature adjustment part is driven upon a constant temperature operation, and the second temperature adjustment part is driven upon a cooling operation, and
the control part operates the first and second temperature adjustment parts simultaneously upon the cooling operation.
